# EUROPEAN PATENT APPLICATION

(11) **EP 2 170 028 A1**
(43) Date of publication of application: **31.03.2010**
(21) Application number: 07790573.5
(22) Date of filing: 10.07.2007
(51) Int. Cl.: H05K 3/46

(54) **WIRING SUBSTRATE, AND ITS MANUFACTURING METHOD**

(71) Applicant: Ibiden Co., Ltd., Ogaki-shi, Gifu 503-8604 (JP)
(72) Inventor: TAKAHASHI, Michimasa, Ogaki-shi Gifu 503-8503 (JP)
(74) Representative: Gendron, Vincent Christian
(86) International application number: PCT/JP2007/063755
(87) International publication number: WO 2009/008066

(57) **Abstract**

The present invention is to provide a wiring board where the risk of rupture in the connection between conductive patterns is minimized if electrical continuity inside the through-hole generates high temperatures. A wiring board 10 that has an insulation layer 161a formed with a base material of resin-impregnated inorganic fabric, a base substrate 121 supporting the insulation layer 161a, a via 114a electrically connecting a conductive pattern 117a formed on the insulation layer 161a and a conductive pattern 113a formed on the base substrate 121, and a through-hole 111 penetrating the base substrate. The hole-diameter of the through-hole 111 is in the range of 10 µm-150 µm.

## Description

### Technical Field

The present invention relates to a rigid wiring board with enhanced interlayer connection reliability and a method of manufacturing the same.

### Background Art

In a wiring board with mounted multiple electronic components used in a cell phone or the like, connection reliability between conductive patterns is required.
However, while an electronic device is in use for a long duration, electronic components inside the electronic device may generate heat. And if the heat from the electronic components is transmitted to the resin filled in a through-hole, the resin filled in the through-hole expands and the insulation layers at the top and bottom portions of the through-hole are pushed up. In such a case, if a conductive pattern is formed either on the top or the bottom portion of the through-hole, since the insulation layer is pushed up, the conductive pattern may warp and the connection between conductive patterns may rupture. Also, by the expansion of the resin filled in the through-hole, the plating in the through-hole may be damaged and the connection between conductive patterns connected via the through-hole may rupture.
Patent Literature 1 describes a technique to configure a through-hole, which connects conductive patterns, such that it is curved slightly outward at a center portion thereof.

This technique can provide an extra space at an outwardly curved center portion of a through-hole, thereby preventing conductive patterns from being uneven or connections from being broken when the insulation layers in the upper and lower portions of the through-hole are pushed up by the resins therein being heated and swollen.
However, to employ this technique, a through-hole must have a sufficiently large diameter.
The flexibility in wiring structure near the center portions of through-holes is compromised, and forming a fine wiring structure may become difficult.
Patent Literature 1: Japanese Patent Application No. 2005-199442.

### Disclosure of Invention

### Problem to be Solved by the Invention

The present invention is to provide a wiring board where the risk of rupture in the connection between conductive patterns is minimized if electrical continuity inside the through-hole generates high temperatures, and a manufacturing method of such a wiring board.

### Means for Solving the Problem

To achieve the above objective, a wiring board according to the first aspect of the present invention has an insulation layer formed with a base material of resin-impregnated inorganic fabric; a base substrate that supports the insulation layer; vias that electrically connect a conductive pattern formed on the insulation layer and a conductive pattern formed on the base substrate; and a through-hole that penetrates the base substrate and has a hole-diameter in the range of 10 µm - 150 µm.

Also, to achieve the above objective, a wiring board according to the second aspect of the present invention has a first upper-layer insulation layer formed with a base material of resin-impregnated inorganic fabric; a first lower-layer insulation layer formed with a base material of resin-impregnated inorganic fabric; a base substrate that supports the first upper-layer insulation layer and the first lower-layer insulation layer; vias that electrically connect the conductive pattern formed on the first upper-layer insulation layer and the conductive pattern formed on the base substrate; vias that electrically connect the conductive pattern formed beneath the first lower-layer insulation layer and the conductive pattern formed beneath the base substrate; and a through-hole which penetrates the base substrate and has a hole-diameter in the range of 10 µm - 150 µm.

Also, to achieve the above objective, a method of manufacturing the wiring board according to the third aspect of the present invention is: in a base substrate having a conductive pattern on the surface, to form a through-hole with a hole-diameter in the range of 10 µm - 150 µm; on the base substrate, to laminate an insulation layer which is formed with a base material of resin-impregnated inorganic fabric and has a conductive pattern on the surface; and in the insulation layer, to form vias that electrically connect the conductive pattern formed on the surface of the insulation layer and the conductive pattern formed on the surface of the base substrate.

Also, to achieve the above objective, a method of manufacturing the wiring board according to the fourth aspect of the present invention is: in a base substrate having a conductive pattern on the surface, to form a through-hole with a hole-diameter in the range of 10 µm - 150 µm; on each of the upper and lower surfaces of the base substrate, to laminate an upper-layer insulation layer and a lower-layer insulation layer that are formed with a base substrate of resin-impregnated inorganic fabric and have a conductive pattern on the surface; in the upper-layer insulation layer, to form vias that electrically connect the conductive pattern formed on the upper-layer insulation layer and the conductive pattern formed on the base substrate; and in the lower-layer insulation layer, to form vias that electrically connect the conductive pattern formed beneath the lower-layer insulation layer and the conductive pattern formed beneath the base substrate.

### Effect of the Invention

According to the present invention, while an electronic device is in use for a long duration, if electrical continuity inside a through-hole has generated high temperatures, the risk of rupture in the connection between conductive patterns may be minimized.

### Brief Description of Drawings

Fig. 1A is a side view of a wiring board according to an embodiment of the present invention.
Fig. 1B is a plan view of a wiring board according to an embodiment of the present invention.
Fig. 2 is a cross-sectional view of a wiring board according to an embodiment of the present invention.
Fig. 3A illustrates a step of a method to manufacture a wiring board according to an embodiment of the present invention.
Fig. 3B illustrates a step of a method to manufacture a wiring board according to an embodiment of the present invention.
Fig. 3C illustrates a step of a method to manufacture a wiring board according to an embodiment of the present invention.
Fig. 3D illustrates a step of a method to manufacture a wiring board according to an embodiment of the present invention.
Fig. 3E illustrates a step of a method to manufacture a wiring board according to an embodiment of the present invention.
Fig. 3F illustrates a step of a method to manufacture a wiring board according to an embodiment of the present invention.
Fig. 3G illustrates a step of a method to manufacture a wiring board according to an embodiment of the present invention.
Fig. 3H illustrates a step of a method to manufacture a wiring board according to an embodiment of the present invention.
Fig. 3I illustrates a step of a method to manufacture a wiring board according to an embodiment of the present invention.
Fig. 3J illustrates a step of a method to manufacture a wiring board according to an embodiment of the present invention.
Fig. 3K illustrates a step of a method to manufacture a wiring board according to an embodiment of the present invention.
Fig. 3L illustrates a step of a method to manufacture a wiring board according to an embodiment of the present invention.
Fig. 3M illustrates a step of a method to manufacture a wiring board according to an embodiment of the present invention.
Fig. 3N illustrates a step of a method to manufacture a wiring board according to an embodiment of the present invention.
Fig. 3O illustrates a step of a method to manufacture a wiring board according to an embodiment of the present invention.
Fig. 3P illustrates a step of a method to manufacture a wiring board according to an embodiment of the present invention.
Fig. 3Q illustrates a step of a method to manufacture a wiring board according to an embodiment of the present invention.
Fig. 4 is a cross-sectional view of a wiring board according to an embodiment of the present invention.
Fig. 5 is a cross-sectional view of a wiring board according to an embodiment of the present invention.
Fig. 6 is a cross-sectional view of a wiring board according to an embodiment of the present invention.
Fig. 7A illustrates a step of a method to manufacture a wiring board according to an embodiment of the present invention.
Fig. 7B illustrates a step of a method to manufacture a wiring board according to an embodiment of the present invention.
Fig. 7C illustrates a step of a method to manufacture a wiring board according to an embodiment of the present invention.
Fig. 7D illustrates a step of a method to manufacture a wiring board according to an embodiment of the present invention.
Fig. 7E illustrates a step of a method to manufacture a wiring board according to an embodiment of the present invention.
Fig. 7F illustrates a step of a method to manufacture a wiring board according to an embodiment of the present invention.
Fig. 7G illustrates a step of a method to manufacture a wiring board according to an embodiment of the present invention.
Fig. 7H illustrates a step of a method to manufacture a wiring board according to an embodiment of the present invention.
Fig. 7I illustrates a step of a method to manufacture a wiring board according to an embodiment of the present invention.

### Explanation of Reference Numerals

- 10: wiring board according to the present invention
- 111: through-hole
- 112: conductive pattern
- 113: conductive pattern
- 114: via
- 115: connection pad
- 116: electronic chip
- 117: conductive pattern
- 121: base substrate
- 122: copper foil
- 124: electroless copper plating
- 125: electrolytic copper plating
- 126: mask resist
- 131: prepreg
- 133: electroless copper plating
- 134: electrolytic copper plating
- 135: mask resist
- 161: insulation layer
- 171: prepreg
- 173: electroless copper plating
- 174: electrolytic copper plating
- 175: mask resist

### Best Mode for Carrying Out the Invention

### (FIRST EMBODIMENT OF A WIRING BOARD ACCORDING TO A SPECIFIC EXAMPLE OF THE PRESENT INVENTION)

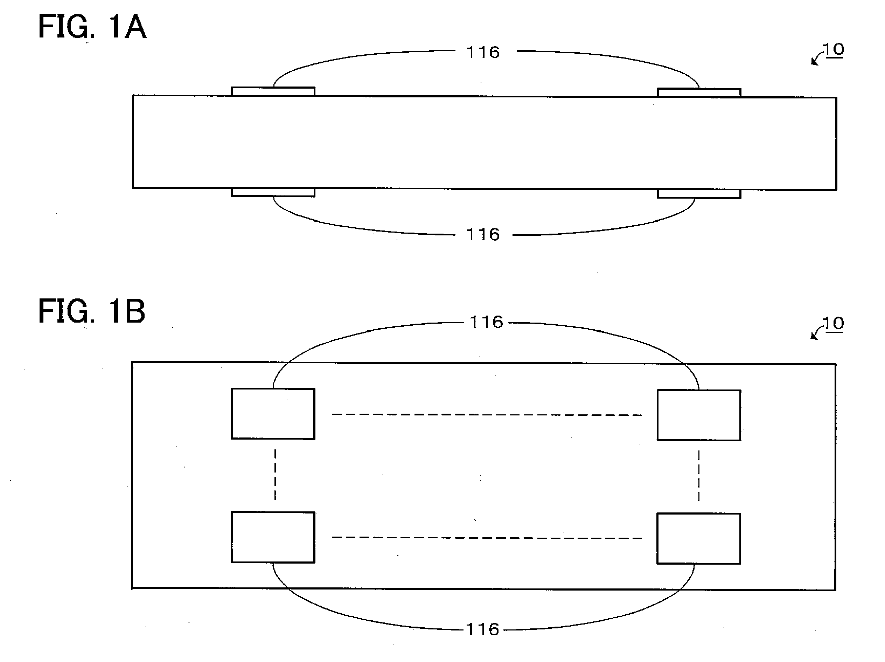

In the following, an embodiment of a wiring board according to the present invention is described with reference to the drawings.
As shown in Figs. 1A and 1B, wiring board 10 according to this embodiment is configured to be rectangular with a thickness of approximately 2 mm. On the upper mounting surface and the lower mounting surface of wiring board 10, multiple electronic chips 116 are mounted respectively.

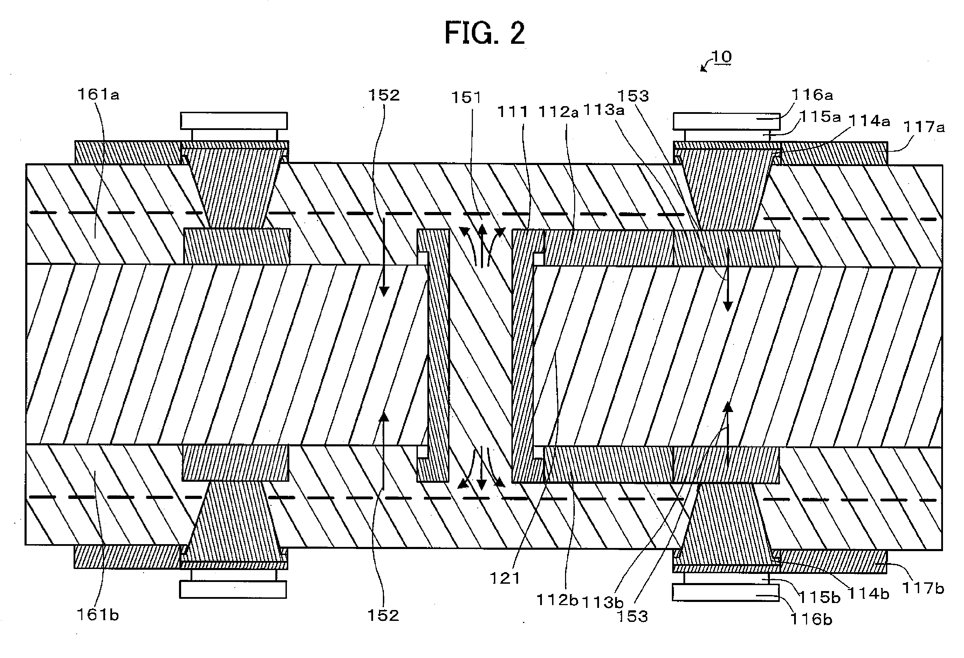

Next, a detailed structure of wiring board 10 having the above overall structure is described with reference to Fig. 2. Wiring board 10 is structured by laminating first upper-layer insulation layer (161 a), base substrate 121 and first lower-layer insulation layer (161b). First upper-layer insulation layer (161a), first lower-layer insulation layer (161b) and base substrate 121 have rectangular shapes, each having the same width and length.

Base substrate 121 is made of a highly rigid material such as glass-epoxy resin. The thickness of base substrate 121 is made 50-100 µm, preferably about 100 µm.
First upper-layer insulation layer (161a) and first lower-layer insulation layer (161b) are also made of glass-epoxy resin. The thickness of first upper-layer insulation layer (161a) and first lower-layer insulation layer (161b) is approximately 10 µm-20 µm. First upper-layer insulation layer (161a) and first lower-layer insulation layer (161b) contain a layer of glass-cloth inorganic fabric. The thickness of the glass cloth is 20 µm and the thickness of the glass fiber forming the glass cloth is 5.0 µm.

On the upper surface of first upper-layer insulation layer (161a) and the lower surface of first lower-layer insulation layer (161b), conductive pattern (117a) and (117b) are formed respectively. On the upper surface of base substrate 121, conductive patterns (112a, 113a) are formed, and on the lower surface of base substrate 121, conductive patterns (112b, 113b) are also formed. Each conductive pattern (117a, 117b, 112a, 112b, 113a, 113b) electrically connects required portions in the circuit substrate.

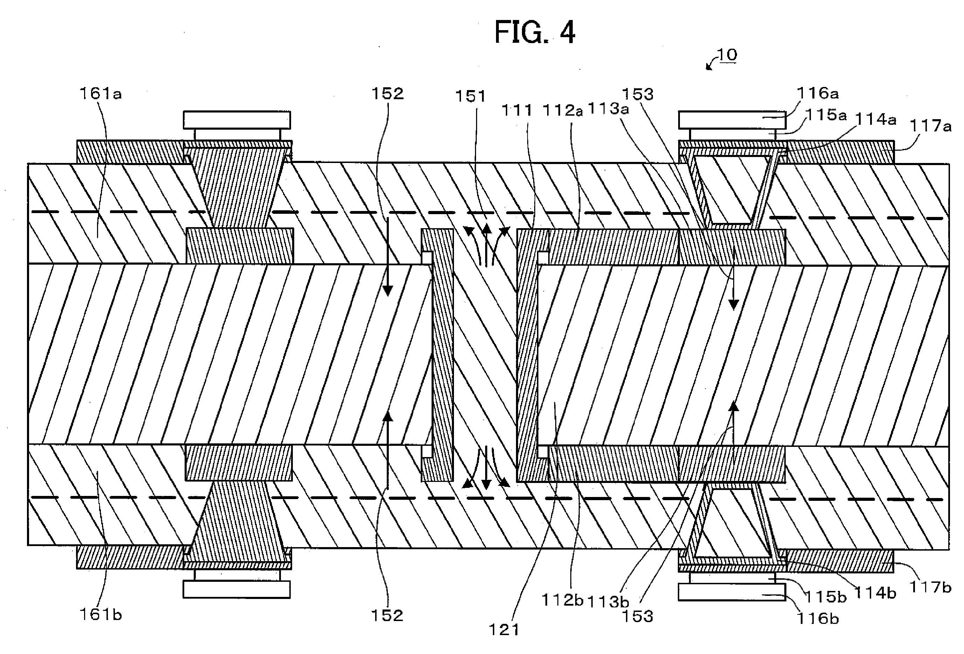

On via (114a), electronic chip (116a) is placed through connection pad (115a). Electronic chip (116a) and conductive pattern (113a) are electrically connected through via (114a). The interior of via (114a) is filled with plated metal. The plated metal is copper. As shown in Fig. 4, the interior of vias (114a, 114b) may be filled with resin such as epoxy resin.

Via diameters of vias (114a, 114b) are in the range of 10 µm - 50 µm; more preferably, in the range of 20 µm - 40 µm. If the via diameter is larger than 50 µm, vias become unsuitable for actualizing a fine wiring structure; and if the via diameter is smaller than 10 µm, connection reliability becomes unstable. In this embodiment, the hole-diameter of vias (114a, 114b) in wiring board 10 is made 40 µm.

Through-hole 111 penetrates base substrate 121. Through-hole 111 electrically connects conductive pattern (112a) on the upper surface of base substrate 121 and conductive pattern (112b) on the lower surface of base substrate 121. Therefore, electronic chip (116a) is electrically connected to electronic chip (116b) through conductive pattern (117a), via (114a), conductive pattern (113a), conductive pattern (112a), through-hole 111, conductive pattern (112b), conductive pattern (113b), via (114b) and conductive pattern (117b). The inner surface of through-hole 111 is metal plated, electrically the connecting conductive patterns. The metal to plate the inner surface of through-hole 111 is copper. The interior of plated through-hole 111 is filled with resin such as epoxy resin.

The hole-diameter of through-hole 111 is in the range of 10 µm - 150 µm; more preferably, in the range of 50 µm - 100 µm. If the hole-diameter is larger than 150 µm, the resin content inside the through-hole is large and if electrical continuity inside the through-hole generates high temperatures, the resin inside the through-hole expands. Accordingly, the insulation layers on the top and bottom portions of the through-hole are pushed up, and the connection between conductive patterns may rupture. Also, if the hole-diameter is smaller than 10 µm, forming fine hole-diameters becomes difficult. As a result, the productivity of manufacturing wiring boards may be lowered and the connection reliability of electrical continuity via through-holes may also be unstable.
In this embodiment, the hole-diameter of through-hole 111 in wiring board 10 is made 150 µm.

The aspect ratio of through-hole 111 is between two (2) and five (5), more preferably between three (3) and four (4). If the aspect ratio is larger than five (5), forming holes with minute diameters becomes difficult, and the productivity of wiring boards may become lowered. Also, if the aspect ratio is smaller than two (2), the resin content inside the through-hole becomes large, and if electrical continuity inside the through-hole generates high temperatures, the resin inside the through-hole expands. Accordingly, the insulation layers on the top and bottom portions of the through-hole are pushed up, and the connection between the conductive patterns may rupture.

Wiring board 10 having the above structure can conduct varieties of signal transmission such as transmitting electrical signals from electronic chip (116a) mounted on first upper-layer insulation layer (161 a) to electronic chip (116b) mounted beneath first lower-layer insulation layer 161.

Also, by setting the hole-diameter of the through-hole in the range of 10 µm - 150 µm, the resin content inside the through-hole is appropriately suppressed. Accordingly, if the electrical continuity inside the through-hole generates high temperatures and the resin inside the through-hole expands, the force (indicated as arrows 151 in Fig. 2) to push up the insulation layers on the top and bottom portions of the through-hole is suppressed, and thus the risk of rupture in the connection between conductive patterns may be minimized.

And, on base substrate 121, insulation layers made with base material of resin-impregnated inorganic fabric are laminated. The insulation layer made with base material of resin-impregnated inorganic fabric has rigidity and strong shape retention. Therefore, even if electrical continuity inside the through-hole generates high temperatures and the resin inside the through-hole expands, thus causing the insulation layers on the top and bottom portions of the through-hole to be pushed up, since the insulation layers have strong shape retention, the resin expansion may be suppressed as shown with arrows 152 in Fig. 2.

Moreover, vias (114a) formed in first upper-layer insulation layer (161 a) physically join first upper-layer insulation layer (161a) and base substrate 121 through conductive pattern (113a). Therefore, even if electrical continuity inside the through-hole generates high temperatures and the resin inside the through-hole expands, since the insulation layer and the base substrate are physically joined, the force to push up the insulation layers on the top and bottom portions of the through-hole may be countered. Since vias (114a) work as if they are anchors when securing insulation layer (161a) to base substrate 121, this effect is named an anchoring effect. If the via diameter is smaller than 10 µm, the force to physically join the insulation layer and the base substrate weakens, and it is difficult to expect an anchoring effect. Therefore, as described above, the via-diameter is preferred to be made 10 µm or larger.

Also, by containing a layer of glass cloth in each insulation layer (161a, 161b), an increase in thickness of the insulation layer is prevented, and if an impact from being dropped is exerted on the wiring board, the insulation layers may absorb the impact. The reasons are: If multiple layers of glass cloth are contained in an insulation layer, the thickness of the insulation layer increases, and the resin content in the insulation layer is lowered, making it difficult to absorb the impact from being dropped.

### (METHOD OF MANUFACTURING A WIRING BOARD ACCORDING TO A SPECIFIC EXAMPLE OF THE PRESENT INVENTION)

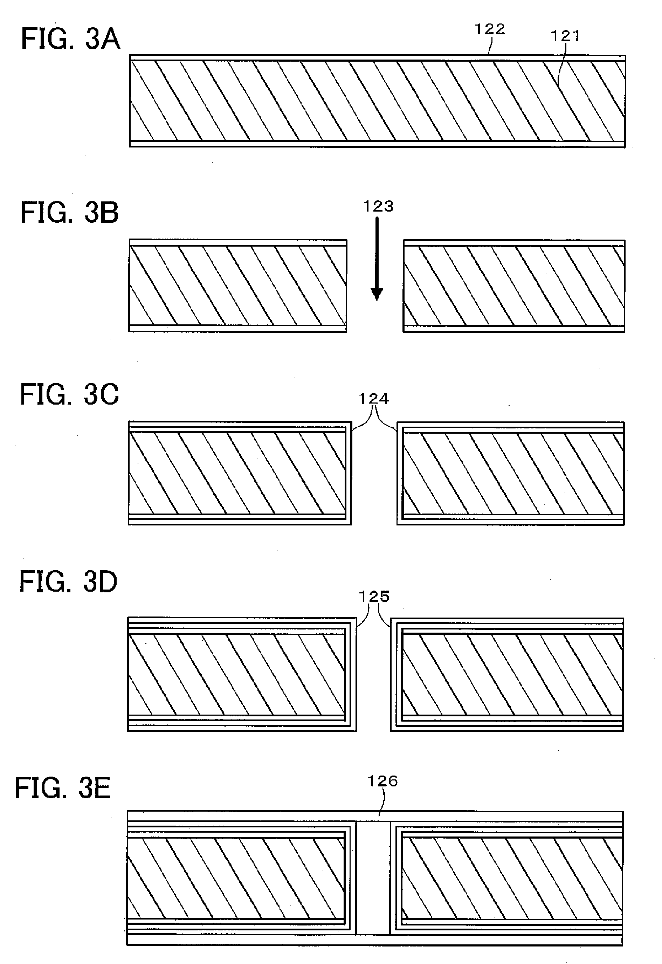

A method of manufacturing wiring board 10 according to the present invention is described as follows. First, as shown in Fig. 3A, a double-sided copper-clad laminate is prepared. The double-sided copper-clad laminate is base substrate 121 with laminated copper foil 122 on both surfaces.

Next, as shown in Fig. 3B, in the double-sided copper-clad laminate, an opening for a through-hole is bored by a drilling process as shown by arrow 123. The diameter of the opening is set in the range of 10 µm - 150 µm. In this embodiment, the opening is 100 µm. Also, the opening may be bored by a laser. A CO₂ laser beamed from CO₂ laser processing equipment may be used. Other than a CO₂ laser, a UV laser or an exima laser may be used. However, a CO₂ laser is preferred, since it is quick in processing and low in production cost.

Next, as shown in Fig. 3C, on the double-sided copper-clad laminate with an opening, electroless copper plating 124 is performed. Before performing electroless copper plating on the opening bored in reference to Fig. 3B, a platinum catalyst is applied to facilitate the reaction in electroless copper plating. The electroless copper plating is performed as follows: in an electroless copper plating solution containing EDTA 150 g/liter, copper sulfate 20 g/liter, HCHO 30 mℓ/liter, NaOH 40 g/liter, α,α'-bipyridyl 80 mg/ liter, and polyethelene glycol 0.1 g/liter, the double-sided copper-clad laminate with an opening is immersed to form 0.5 µm-thick electroless copper plating film 124 on the entire surface. The electroless plating solution is set at 60°C and the immersion time is set for approximately 30 minutes.

Next, as shown in Fig. 3D, by performing electrolytic copper plating, 14 µm-thick electrolytic copper plating 125 is formed. An electrolytic plating solution, containing sulfuric acid 180 g/liter, copper sulfate 80 g/liter and additive (Cupracid GL made by Atotech Japan) 1 mℓ/liter, was used. Conditions for electrolytic plating are current density of 1 A/dm² and electrolytic copper plating time of approximately 30 minutes. Following the electrolytic copper plating, resin material is poured into the through-hole. For the resin material, for example, a solvent-type epoxy-resin is used. The resin material is heated. The heating is conducted for an hour and the temperature is set, for example, at 170°C. Accordingly, the resin material is cured. Resin material that has overflowed from the through-hole is removed by buff-polishing.

Next, as shown in Fig. 3E, mask resist 126 is laminated. For the mask resist, a commercially available dry film, for example, "H9040" made by Hitachi Chemical, is used.

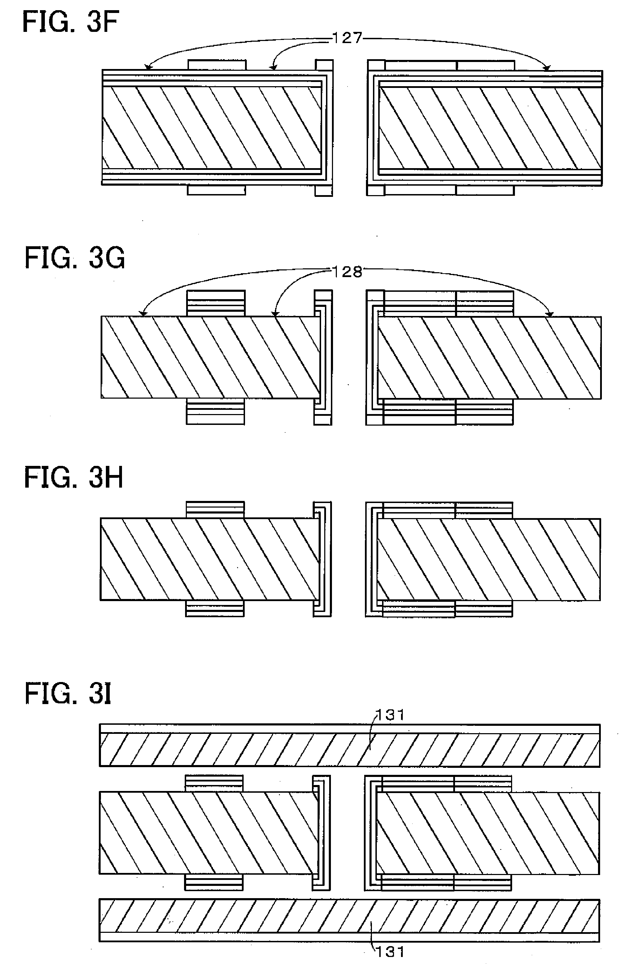

Next, as shown in Fig. 3F, at the predetermined portions indicated by arrows 127, the mask resist is exposed to light and developed using a 0.8 %-sodium carbonate solution.

Next, as shown in Fig. 3G, the predetermined portions indicated by arrows 128 are etched using a copper (II) chloride solution. For the etching solution, it is not limited to a copper (II) chloride solution, but a persulfate solution such as sulfuric acid-hydrogen peroxide, ammonium persulfate, sodium persulfate or potassium persulfate, or an iron (II) chloride solution may be used.

Then, as shown in Fig. 3H, the mask resist is removed using a 5 %-potassium hydroxide solution.

Next, as shown in Fig. 3I, low-flow prepreg 131 made of glass-epoxy resin is laminated. On one side of prepreg 131, a copper foil is arranged. As for the prepreg, for example, a commercially available "R1551" made by Matsushita Electric Works, Ltd. is used. The prepreg is prepared by impregnating glass-cloth inorganic fabric with epoxy resin, then by preliminarily thermosetting the resin to advance the level of cure. The resin to make the prepreg is preferably one with low-flow characteristics. However, resin with regular flow characteristics may be used. Also, the prepreg may be prepared by reducing the amount of epoxy-resin to be impregnated in glass-cloth inorganic fabric. After laminating prepreg 131, pressure is applied. Pressure is applied, for example, by hydraulic power using hydraulic pressing equipment under conditions calling for temperature of 200°C, pressure of 40 kgf and pressing time of three (3) hours. By doing so, resin is squeezed out from the prepreg and the prepreg and the core material will be integrated. Also, pressure may be applied using vacuum pressing instead of hydraulic pressing. By conducting vacuum pressing, bubbles may be prevented from mixing into the resin which forms the insulation layers. Vacuum pressing is conducted, for example, for an hour. Peak temperature is set, for example, at 175°C. Vacuum pressing pressure is set, for example, at 3.90 x 10⁶ [Pa].

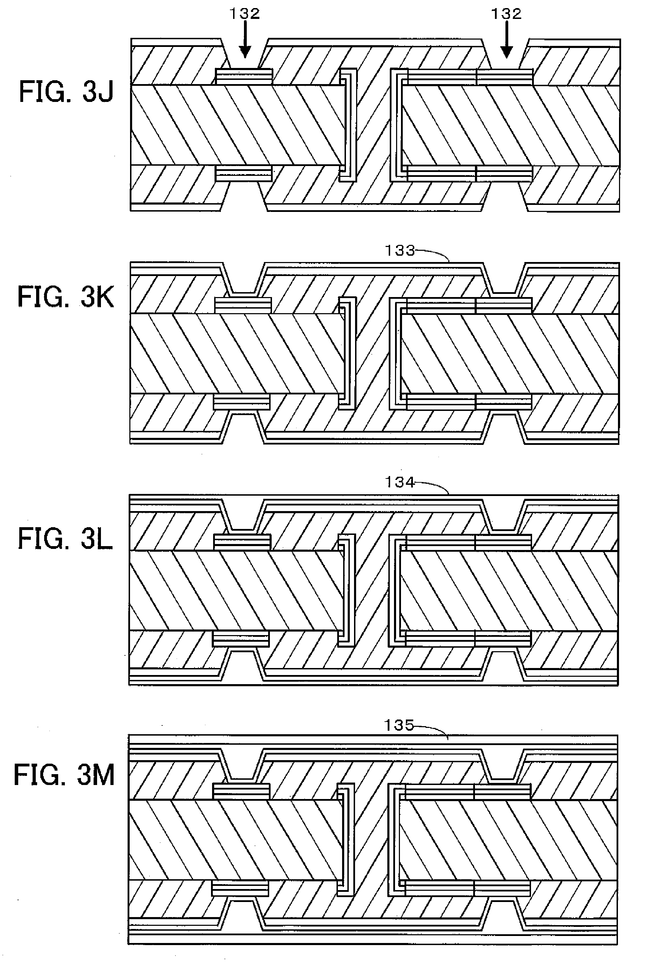

Next, as shown by arrows 132 in Fig. 3J, in glass-epoxy insulation resin, openings to form via holes are bored. Those openings may be bored by beaming a laser. For example, a PET film as protection film is laminated on the epoxy-resin surface, and a carbon dioxide gas laser is beamed on the PET film from above, and openings penetrating the PET film are formed. The PET film is preferably 10-50 µm thick. Then, to remove the resin residue remaining on the side and bottom surfaces of the openings formed by beaming a laser, a desmearing treatment is performed. The desmearing process is performed by a plasma-oxide discharge treatment, corona discharge treatment, ultra-violet laser treatment or exima laser treatment. In the openings formed by beaming a laser, conductive material is filled to form filled-via holes. For the conductive material, a conductive paste or metal plating formed by an electrolytic plating process is preferred. For example, vias are filled with conductor by copper plating or the like. To lower production cost and to improve productivity by simplifying the production process of filled-via holes, filling with a conductive paste is preferred. For example, a conductive paste (such as thermosetting resin containing conductive particles) may be printed by screen printing, filled in vias and cured. By filling the interior of vias with the same conductive paste material, connection reliability when thermo-stress is exerted on vias may be improved. On the other hand, regarding connection reliability, metal plating formed by an electrolytic plating process is preferred. Especially electrolytic copper plating is preferred.

Next, as shown in Fig. 3K, electroless copper plating 133 is formed to be 0.3 µm-3.0 µm. Electroless copper plating is performed at a temperature of 34°C for 45 minutes.

Then, as shown in Fig. 3L, electrolytic copper plating 134 is formed. An electrolytic plating solution containing sulfuric acid 2.24 mol/liter, copper sulfate 0.26 mol/liter, and additive 19.5 mℓ/liter, leveling agent 50 mg/liter and polishing agent 50 mg/liter was used. Conditions for electrolytic plating are current density of 1 A/dm², electrolytic plating time of approximately 70 minutes and temperature of about 22°C.

Next, as shown in Fig. 3M, mask resist 135 is laminated. For the mask resist, a commercially available dry film, for example, "H9040" made by Hitachi Chemical, is used.

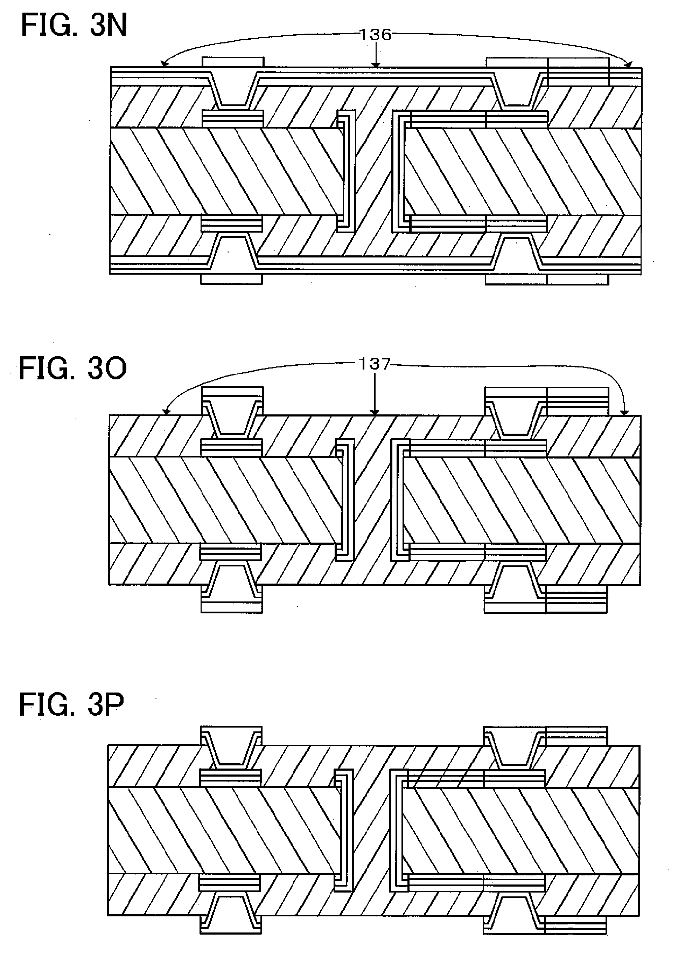

Next, as shown in Fig. 3N, at the prescribed portions indicated by arrows 136, the mask resist is exposed to light and developed using a 0.8 %-sodium carbonate solution.

Next, as shown in Fig. 3O, the portions indicated by arrows 137 are etched using a copper (II) chloride solution.

Then, as shown in Fig. 3P, the mask resist is removed using a 5 %- potassium hydroxide solution.

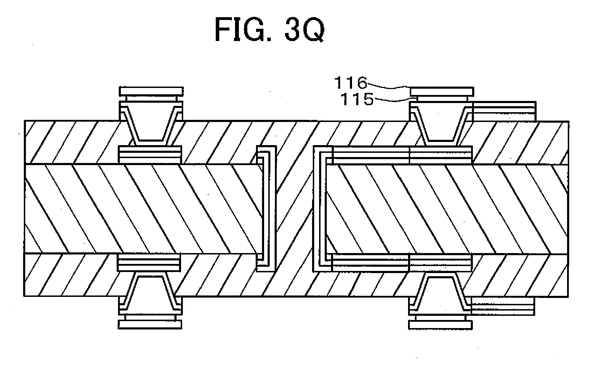

Lastly, as shown in Fig. 3Q, electronic chips 116 are mounted on the vias through connection pads 115.

### (SECOND EMBODIMENT OF A WIRING BOARD ACCORDING TO A SPECIFIC EXAMPLE OF THE PRESENT INVENTION)

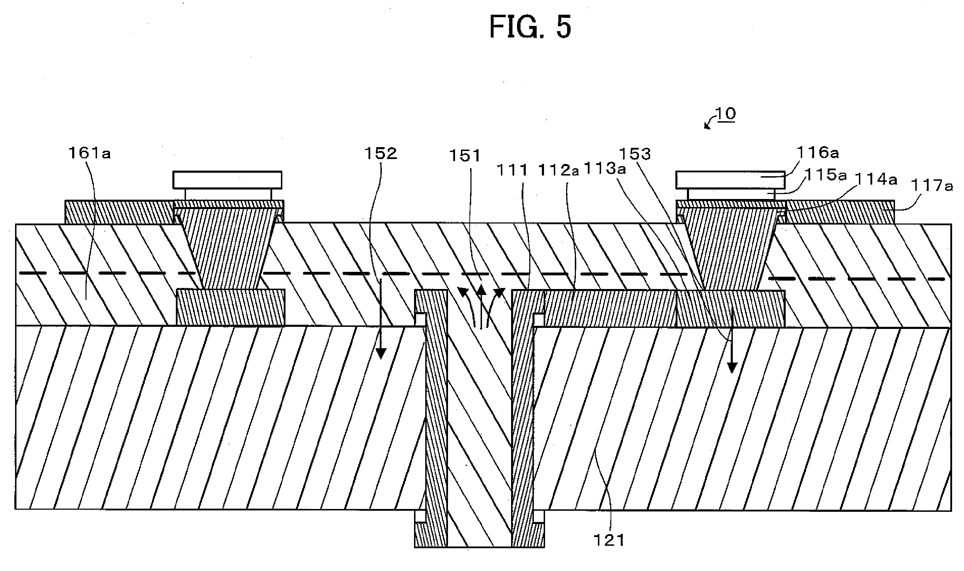

As shown in Fig. 5, in wiring board 10 according to the Second Embodiment, unlike the wiring board according to the First Embodiment, a first lower-layer insulation layer is not formed. The rest of the structure is the same as the wiring board according to the First Embodiment.

Wiring board 10 according to the Second Embodiment is used when a conductive pattern is not required to be formed in the lower portion of base substrate 121. In proportion to an insulation layer which is not formed under base substrate 121 of wiring board 10, the overall thickness of the wiring board may be reduced. Therefore, for example, the wiring board may be used in an ultra-thin-type cell phone or the like.

The method of manufacturing wiring board 10 according to the Second Embodiment is the same as that in reference to Figs. 3A-3Q, except for the step for laminating an insulation layer under the base substrate.

### (THIRD EMBODIMENT OF A WIRING BOARD ACCORDING TO A SPECIFIC EXAMPLE OF THE PRESENT INVENTION)

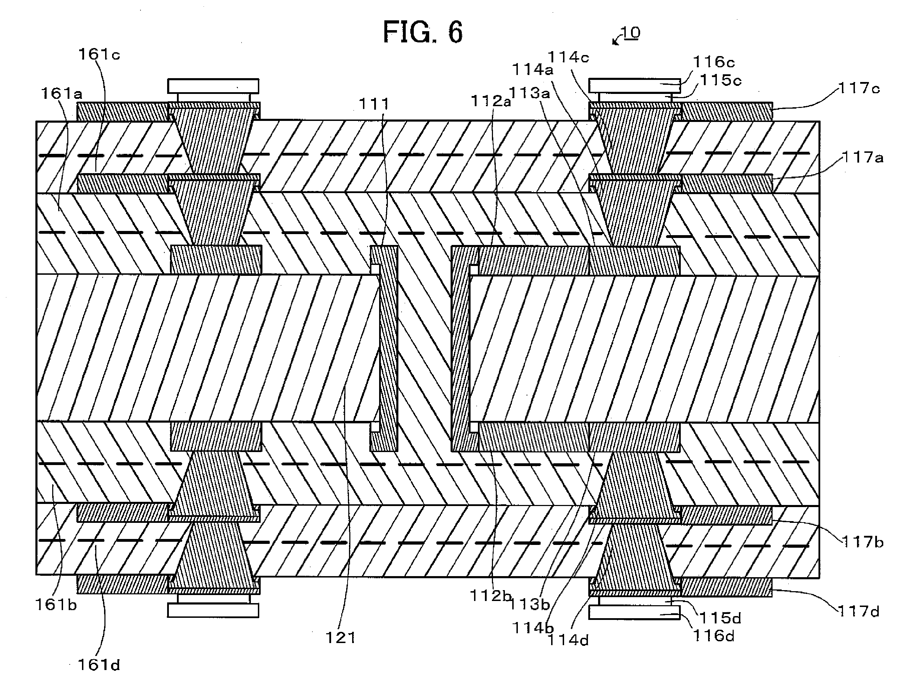

As shown in Fig. 6, wiring board 10 according to the Third Embodiment is different from the wiring board according to the First Embodiment; on first upper-layer insulation layer (161a), second upper-layer insulation layer (161 c) is laminated, and under first lower-layer insulation layer (161b), second lower-layer insulation layer (161 d) is laminated. Second upper-layer insulation layer (161c) and second lower-layer insulation layer (161 d) are made of epoxy resin. The thickness of second upper-layer insulation layer (161c) and second lower-layer insulation layer (161d) is approximately in the range of 10 µm-20 µm. Second upper-layer insulation layer (161c) and second lower-layer insulation layer (161d) contain a layer of glass-cloth inorganic fabric. The glass cloth is 20 µm thick and the width of the glass fiber forming the glass cloth is 5.0 µm.

On the top surface of second upper-layer insulation layer (161c) and the bottom surface of second lower-layer insulation layer (161 d), conductive pattern (117c) and (117d) are formed respectively. In second upper-layer insulation layer (161c), vias (114c) are formed, and in second lower-layer insulation layer (161d), vias (114d) are formed. On vias (114c), through connection pads (115c), electronic chips (116c) are mounted. Conductive pattern (117c) and conductive pattern (113a) are electrically connected through stacked vias (114a, 114c). Conductive pattern (117d) and conductive pattern (113b) are electrically connected through stacked vias (114b, 114d). Through stacked vias (114a, 114c) and stacked vias (114b, 114d), the wiring length is made shorter, and thus a wiring board that is suitable for mounting electronic components which require large amounts of electricity may be provided.

The interiors of vias (114c, 114d) are filled with plating metals. The plating metal is copper. The via-diameter of vias (114c, 114d) is in the range of 10 µm-50 µm, more preferably in the range of 20 µm-40 µm.

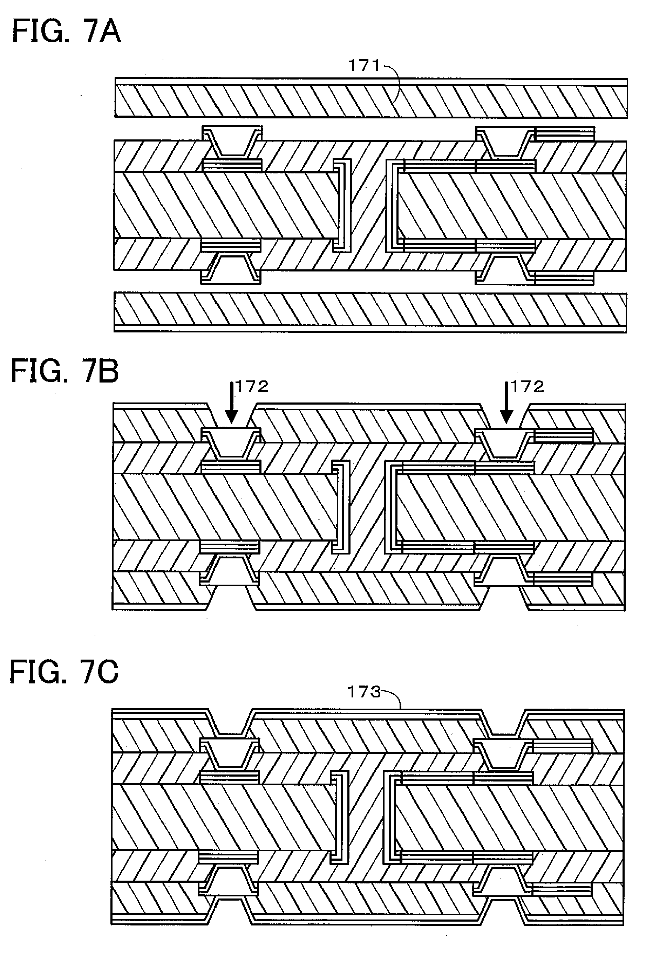

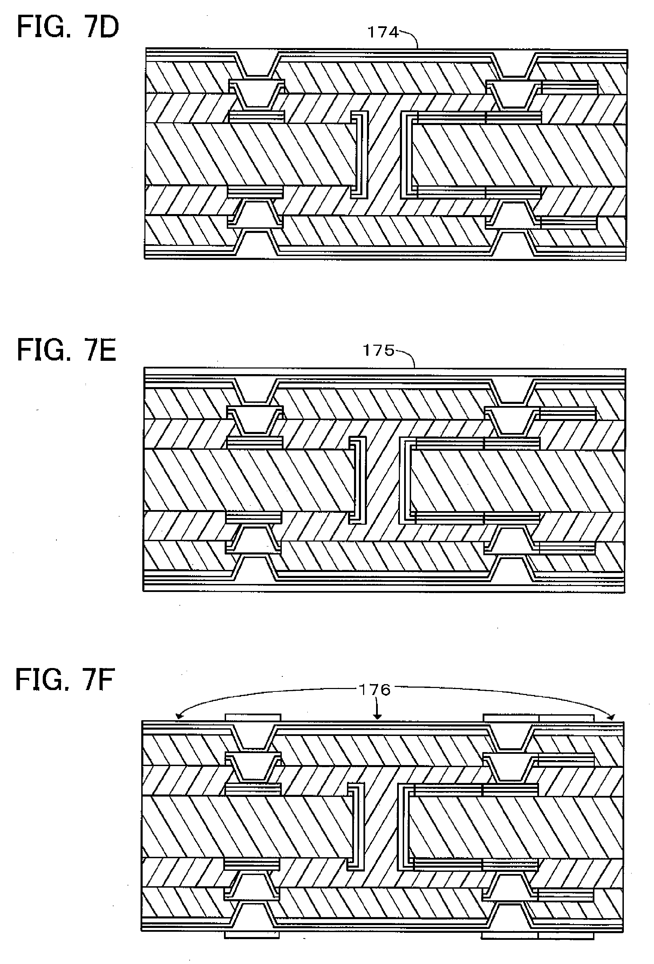

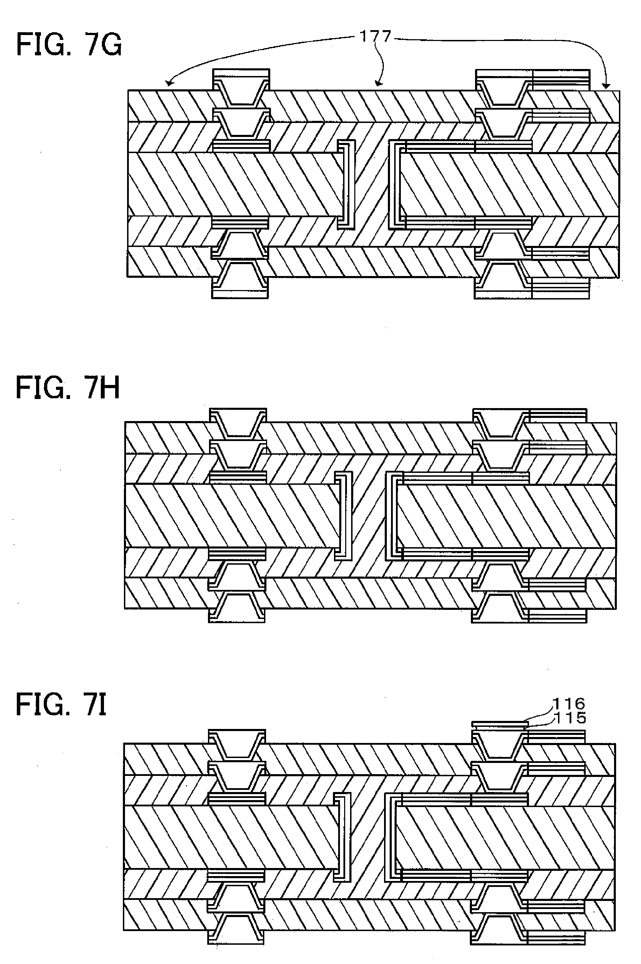

The method of manufacturing wiring board 10 according to the Third Embodiment is the same manufacturing method as in the First Embodiment in reference to Figs. 3A-3Q. And, following Fig. 3Q, as shown in Fig. 7A, low-flow prepreg 171 made of glass-epoxy resin is laminated. On one surface of prepreg 171, a copper foil is deposited. A commercially available prepreg, for example, "R1551" made by Matsushita Electric Works, Ltd., is used. After prepreg 171 is laminated, pressure is applied. Next, as shown by arrows 172 in Fig. 7B, in glass-epoxy insulation resin, openings for forming via-holes are made. Those openings may be made by beaming a laser. Next, as shown in Fig. C, electroless copper plating 173 with a thickness in the range of 0.3 µm-3.0 µm is performed. Next, as shown in Fig. 7D, electrolytic copper plating 174 is performed. Next, as shown in Fig. 7E, mask resist 175 is laminated. Next, as shown in Fig. 7F, at the predetermined portions indicated by arrows 176, the mask resist is exposed to light and developed. Next, as shown in Fig. 7G, at the predetermined portions indicated by arrows 177, etching is conducted. And, as shown in Fig. 7H, the mask resist is removed. Lastly, as shown in Fig. 7I, electronic chip 116 is mounted on the via through connection pad 115.

### (OTHER EMBODIMENTS IN THE PRESENT INVENTION)

Also, in the First Embodiment, insulation layers are formed with glass epoxy resin. However, the material is not limited to such. As for base material of resin-impregnated glass cloth, base material such as bismaleimide-triazine resin-impregnated glass cloth, polyphenylen ether resin-impregnated glass cloth, epoxy resin-impregnated alamide non-woven fabric, or polyimide-impregnated alamide non-woven fabric may also be used.

Also, if glass epoxy resin is used, as for the epoxy resin, naphthalene-type epoxy resin, dicyclo-pentadiene-type epoxy resin, biphenyl-type epoxy resin, bisphenole-A-type epoxy resin, bisphenol-F-type epoxy resin, bisphenol-S-type epoxy resin, phenol novolac-type epoxy resin, alkylphenol novolac-type epoxy resin, alalkyl-type epoxy resin, biphenol-type epoxy resin, anthracene-type epoxy resin, epoxydated condensation of a phenolic group and aromatic compound aldehyde containing a phenolic hydroxyl group, triglycidyl isocyanurate, or alicyclic epoxy resin may be used.

Also, in the First Embodiment, the thickness of the glass cloth was 20 µm and the width of the glass fiber forming the glass cloth was 5.0 µm. However, glass cloth is not limited to such. Glass cloth having a thickness of 30 µm or less, with the diameter of its glass fiber in the range of 1.5-7.0 µm thick may be selected. That is because if the thickness of glass cloth exceeds 30 µm, the thickness of insulation layers becomes too large; if the width of the glass fiber is less than 1.5 µm, the rigidity of insulation layers is not sufficient; and if it exceeds 7.0 µm, it is difficult to ease impact intensity at insulation layers.

Also, in the First Embodiment, for the inorganic fabric contained in insulation layers, glass cloth was used. However, it is not limited to such. As for inorganic fabric, for example, alumina fabric, carbon fabric (carbon fiber), silicon carbide fabric or silicon nitride fabric may be used.

Also, in the First Embodiment, base substrate 121 was formed using glass epoxy resin. However, it is not limited to such. For base substrate 121, resin made of polycarbonate, denaturated polyphenylen ether, polyphenylen oxide, polybutylene-telephtalate, polyacrylate, polysulfone, polyphenylen-sulfid, polyether-etherketone, tetrafluoroethylene, bismaleimide, polysulfone, polyethersulfone, polyphenylsulfone, polyphthalamide, polyamide-imide, polyketone or polyacetale may be used.

### Industrial Applicability

The present invention may be used in a wiring board that can mount electronic components, specifically in a wiring board that can mount electronic components to be used in a compact electronic device.

## Claims

1. A wiring board (10), comprising
an insulation layer (161) formed with a base substrate of resin-impregnated inorganic fabric;
a base substrate (121) that supports the insulation layer (161);
a via (114) that electrically connects a conductive pattern (117) formed on the insulation layer (161) and a conductive pattern (113) formed on the base substrate (121); and
a through-hole (111) that penetrates the base substrate (121) and has a hole diameter in the range of 10 µm-150 µm.

2. The wiring board (10) according to Claim 1, wherein the via (114) is filled with plating metal.

3. The wiring board (10) according to Claim 1, wherein the via (114) is filled with resin.

4. The wiring board (10) according to Claim 1, wherein a via-diameter of the via (114) is in the range of 10 µm-50 µm.

5. The wiring board (10) according to Claim 1, wherein the aspect ratio of the through-hole (111) is in the range of 2-5.

6. The wiring board (10) according to Claim 1, wherein the inorganic fabric is glass cloth.

7. The wiring board (10) according to Claim 6, wherein the glass cloth contained in the insulation layer (161) is one layer.

8. The wiring board (10) according to Claim 1, wherein the through-hole (111) electrically connects a conductive pattern (112a) formed on the base substrate (121) and a conductive pattern (112b) formed underneath the base substrate (121).

9. The wiring board (10) according to Claim 1, wherein the interior of the through-hole (111) is filled with resin.

10. The wiring board (10) according to Claim 1, wherein the base substrate (121) is formed with resin containing glass epoxy resin.

11. A wiring board, comprising:
a first upper-layer insulation layer (161a) formed with a base material of resin-impregnated inorganic fabric;
a first lower-layer insulation layer (161b) formed with a base material of resin-impregnated inorganic fabric;
a base substrate (121) that supports the first upper-layer insulation layer (161a) and the first lower-layer insulation layer (161b);
a via (114a) that electrically connects a conductive pattern (117a) formed on the first upper-layer insulation layer (161a) and a conductive pattern (113a) formed on the base substrate (121);
a via (114b) that electrically connects a conductive pattern (117b) formed underneath the first lower-layer insulation layer (161b) and a conductive pattern (113b) formed underneath the base substrate (121); and
a through-hole (111) that penetrates the base substrate (121) and has a hole-diameter in the range of 10 µm to 150 µm.

12. The wiring board (10) according to Claim 11, wherein the vias (114a, 114b) are filled with plating metal.

13. The wiring board (10) according to Claim 11, wherein via-diameters of the vias (114a, 114b) are in the range of 10 µm-50 µm.

14. The wiring board (10) according to Claim 11, wherein the aspect ratio of the through-hole (111) is in the range of 2-5.

15. The wiring board (10) according to Claim 11, wherein the inorganic fabric is glass cloth.

16. The wiring board (10) according to Claim 15, wherein the glass cloth contained in the upper-layer insulation layer (161a) and the lower-layer insulation layer (161b) is one layer.

17. The wiring board (10) according to Claim 11, further comprising:
a second upper-layer insulation layer (161c) formed on the first upper-layer insulation layer (161 a);
a second lower-layer insulation layer (161d) formed under the first lower-layer insulation layer (161b);
a via (114c) formed in the second upper-layer insulation layer (161c); and
a via (114d) formed in the second lower-layer insulation layer (161d).

18. The wiring board (10) according to Claim 17, wherein a conductive pattern (117c) formed on the second upper-layer insulation layer (161c) and a conductive pattern (113a) formed on the base substrate (121) are connected through stacked vias (114a, 114c), and a conductive pattern (117d) formed underneath the second lower-layer insulation layer (161d) and a conductive pattern (113b) formed underneath the base substrate (121) are connected through stacked vias (114b, 114d).

19. A method of manufacturing a wiring board (10), comprising:
in a base substrate (121) having a conductive pattern (113) on the surface, forming a through-hole (111) with a hole-diameter in the range of 10 µm-150 µm;
on the base substrate (121), laminating an insulation layer (161) that is made of a base material of resin-impregnated inorganic fabric and has a conductive pattern (117) on its surface; and
in the insulation layer (161), forming a via (114) that electrically connects the conductive pattern (117) formed on the surface of the insulation layer (161) and the conductive pattern (113) formed on the surface of the base substrate (121).

20. The method of manufacturing a wiring board according to Claim 19, wherein the via (114) is filled with plating metal.

21. The method of manufacturing a wiring board according to Claim 19, wherein the via (114) is filled with resin.

22. The method of manufacturing a wiring board according to Claim 19, wherein the via-diameter of the via (114) is in the range of 10 µm-5 0 µm.

23. The method of manufacturing a wiring board according to Claim 19, wherein the aspect ratio of the through-hole (111) is in the range of 2-5.

24. The method of manufacturing a wiring board according to Claim 19, wherein the inorganic fabric is glass cloth.

25. The method of manufacturing a wiring board according to Claim 24, wherein the glass cloth contained in the insulation layer (161) is one layer.

26. The method of manufacturing a wiring board according to Claim 19, wherein the through-hole (111) electrically connects a conductive pattern (112a) formed on the base substrate (121) and a conductive pattern (112b) formed underneath the base substrate (121).

27. The method of manufacturing a wiring board according to Claim 19, wherein the interior of the through-hole (111) is filled with resin.

28. The method of manufacturing a wiring board according to Claim 19, wherein the base substrate (121) is made of resin containing glass epoxy resin.

29. A method of manufacturing a wiring board, comprising:
in a base substrate (121) having a conductive pattern (113) on the surface, forming a through-hole (111) with a hole-diameter in the range of 10 µm-150 µm;
on the top surface or the bottom surface of base substrate (121), laminating a first upper-layer insulation layer (161a) or a first lower-layer insulation layer (161b) made of a base material of resin-impregnated inorganic fabric and having a conductive pattern (117a) or (117b) on its surface;
in the first upper-layer insulation layer (161a), forming a via (114a) that electrically connects the conductive pattern (117a) formed on the first upper-layer insulation layer (161a) and the conductive pattern (113a) formed on the base substrate (121); and
in the first lower-layer insulation layer (161b), forming a via (114b) that electrically connects the conductive pattern (117b) formed underneath the first lower-layer insulation layer (161b) and the conductive pattern (113b) formed underneath the base substrate (121).

30. The method of manufacturing a wiring board (10) according to Claim 29, wherein the vias (114a, 114b) are filled with plating metal.

31. The method of manufacturing a wiring board according to Claim 29, wherein the via-diameters of the vias (114a, 114b) are in the range of 10 µm-50 µm.

32. The method of manufacturing a wiring board according to Claim 29, wherein the aspect ratio of the through-hole (111) is in the range of 2-5.

33. The method of manufacturing a wiring board according to Claim 29, wherein the inorganic fabric is glass cloth.

34. The method of manufacturing a wiring board according to Claim 33, wherein the glass cloth contained in the upper-layer insulation layer (161a) and the lower-layer insulation layer (161b) is one layer.

35. The method of manufacturing a wiring board according to Claim 29, further comprising:
laminating a second upper-layer insulation layer (161c) on the upper-layer insulation layer (161 a);
laminating a second lower-layer insulation layer (161d) under the first lower-layer insulation layer (161b);
forming a via (114c) in the second upper-layer insulation layer (161 c); and
forming a via (114d) in the second lower-layer insulation layer (161d).
